Europäisches Patentamt

European Patent Office

Office européen des brevets

(11) Veröffentlichungsnummer: **0 337 265**
A1

(12) **EUROPÄISCHE PATENTANMELDUNG**

(21) Anmeldenummer: 89105929.7

(22) Anmeldetag: 05.04.89

(51) Int. Cl.⁴: **G01R 15/04**

(30) Priorität: 12.04.88 DE 3812055

(43) Veröffentlichungstag der Anmeldung:
18.10.89 Patentblatt 89/42

(84) Benannte Vertragsstaaten:
AT BE CH DE LI NL

(71) Anmelder: **MASCHINENFABRIK REINHAUSEN GMBH**
**Falkensteinstrasse 8**
**D-8400 Regensburg(DE)**

(72) Erfinder: **Kugler, Kurt, Dipl. Ing.(FH)**
**Hainsacker Kellerweg 12**
**D-8417 Lappersdorf(DE)**

(54) Verfahren zum Korrigieren der von einem in einem Drehstromsystem angeordneten Koppelstützisolator abgegebenen Messspannung.

(57) Verfahren zum Korrigieren der von einem in einer Phase eines Drehstromsystems angeordneten Koppelstützisolator abgegebenen Meßspannung. Die Meßspannung wird einer elektronischen Rechenschaltung zugeführt, die zwei den beiden anderen Phasen zugeordnete Korrekturfaktoren berücksichtigt. Die Korrekturfaktoren werden vor der eigentlichen Spannungsmessung im Drehstromsystem ermittelt, indem zunächst jede Phase einzeln unter Spannung gesetzt wird und dabei deren Einfluß auf die benachbarten Phasen ermittelt wird.

Fig.1

EP 0 337 265 A1

# Verfahren zum Korrigieren der von einem in einem Drehstromsystem angeordneten Koppelstützisolator abgegebenen Meßspannung

Es ist bekannt, für Meßzwecke in der Elektrotechnik sogenannte Koppelstützisolatoren einzusetzen. Ein Koppelstützisolator arbeitet hierbei wie ein kapazitiver Meßteiler mit nachfolgendem elektronischem Verstärker, wobei die Ausgangsspannung des Verstärkers direkt für Meßzwecke verwendet werden kann. Meßteiler und Verstärker sind dabei im Stützisolator integriert (DE 31 21 795 A1).

Die bekannte Anordnung kann prinzipiell auch in Drehstromsystemen eingesetzt werden. Jedoch ist hierbei zu beachten, daß die an den Koppelstützisolatoren auftretende Ausgangsspannung der einzelnen Verstärker in den einzelnen Phasen durch gegenseitige Beeinflussung verfälscht sein kann. Bedingt durch die räumliche Nähe der Koppelstützisolatoren der einzelnen Phasen und der relativ offenen Bauform der Stützer mit ihren entsprechenden Teilerkapazitäten bewirken die ferner vorhandenen parasitären Kapazitäten zwischen den Phasen eine zum Teil erhebliche Verfälschung der Meßwerte. Das bedeutet, daß z.B. die Ausgangsspannung eines Verstärkers einer Phase nicht mehr proportional der am Stützer dieser Phase anliegenden Hochspannung ist. Diese Ausgangsspannung enthält vielmehr auch gewisse von den benachbarten Phasen herrührende Anteile.

Es ist Aufgabe der Erfindung ein Meßverfahren anzugeben, um die von einem Koppelstützisolator in einem Drehstromsystem abgegebene durch die gegenseitige Beeinflussung der einzelnen Phasen verfälschte Meßspannung zu korrigieren. Diese Aufgabe wird erfindungsgemäß durch das im Patentanspruch angegebene Verfahren gelöst.

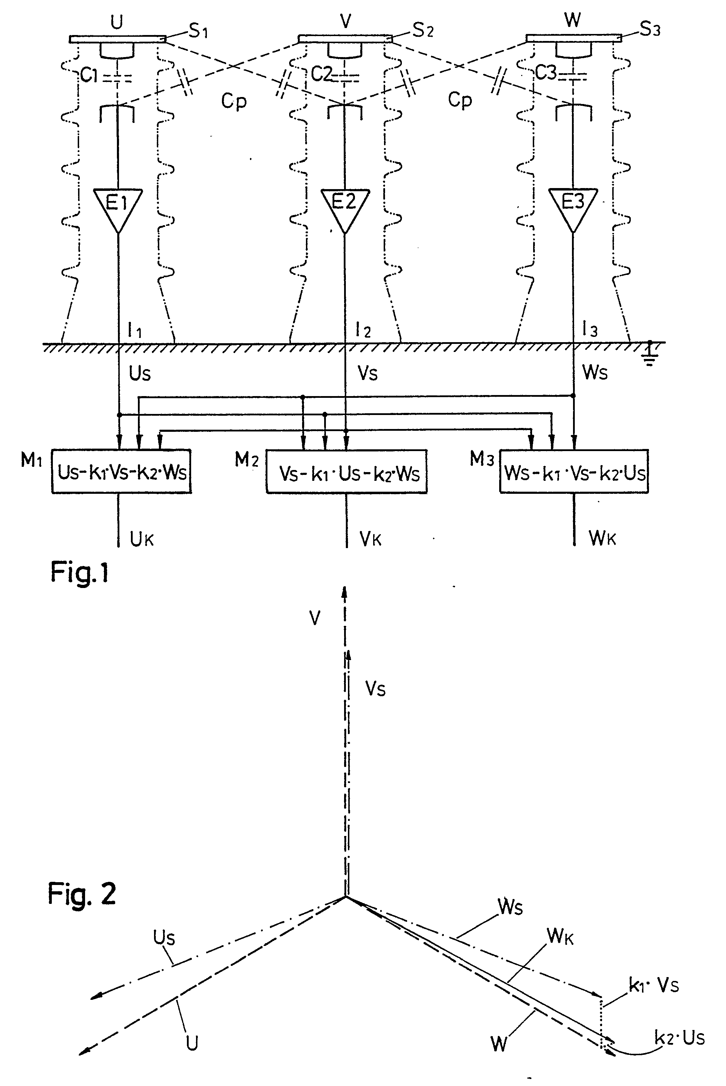

Die Erfindung wird nachstehend an Hand der Figuren 1 und 2 noch näher erläutert.

Die Figur 1 zeigt zunächst eine prinzipielle Anordnung in einem Drehstromsystem. Hierbei tragen die Stützer J1, J2, J3 jeweils eine Stromschiene S1, S2, S3. Jeder Stützer ist als Koppelstützer mit einer jeweiligen Teilerkapazität C1, C2, C3 und einer elektronischen Verstärkerschaltung E1, E2, E3 ausgerüstet. Die zwischen den einzelnen Phasen U, V, W ferner vorhandenen parasitären Kapazitäten sind mit Cp bezeichnet. Diese parasitären Kapazitäten Cp führen zu einer Verfälschung der Ausgangsspannungen Us, Vs, Ws der elektronischen Verstärker E1, E2, E3. Es ist deshalb jede Ausgangsspannung Us, Vs, Ws jedes Verstärkers E1, E2, E3 einer elektronischen Rechenschaltung M1, M2, M3 zugeführt. In diesen Rechenschaltungen M1, M2, M3 wird jeweils der nach dem oben beschriebenen Verfahren ermittelte Korrekturfaktor, der auf die Beeinflussung durch die Nachbarphasen zurückgeht, berücksichtigt, so daß sich die korrigierten Meßausgangsspannungen wie folgt darstellen: Uk = Us - K1 x Vs - K2 x Ws bzw. Vk = Vs - K1 x Us - K2 x Ws, bzw. Wk = Ws - K1 x Vs - K2 x Us.

Die Figur 2 zeigt ein Vektordiagramm zur Veranschaulichung der einzelnen Spannungsgrößen, wobei lediglich beispielsweise auf Phase W eingegangen wird: die tatsächlich auftretende Spannung ist mit W bezeichnet. Ws ist die vom Verstärker E3 gelieferte Spannung, während Wk die von der Rechenschaltung korrigierte Spannung zeigt.

## Ansprüche

Verfahren zum Korrigieren der von einem in einer Phase (z.B. U) eines Drehstromsystems angeordneten Koppelstützisolator (z.B. J1) abgegebenen Meßspannung (z.B Us),
dadurch gekennzeichnet,
daß die Meßspannung einer elektronischen Rechenschaltung (z.B. M1) zugeführt wird, die zwei den beiden anderen Phasen (V, W) zugeordnete Korrekturfaktoren (K1, K2) berücksichtigt, wobei diese Korrekturfaktoren wie folgt bestimmt werden:
es wird lediglich die erste benachbarte Phase (V) an Spannung gelegt
in der elektronischen Rechenschaltung (M1) wird der dieser ersten benachbarten Phasen zugeordnete Korrekturfaktor (K1) so eingestellt, daß die Ausgangsmeßspannung (Uk) Null wird
danach wird lediglish die zweite benachbarte Phase (W) an Spannung gelegt und in der elektronischen Rechenschaltung (M1) wird der dieser zweiten benachbarten Phase zugeordnete Korrekturfaktor (K2) wiederum so eingestellt, daß die Ausgangsmeßspannung (Uk) Null wird
danach wird das Drehstromsystem betriebsmäßig unter Spannung gesetzt, wobei sich eine korrigierte Meßausgangsspannung (Uk) an der elektronischen Rechenschaltung (M1) zu
UK = Us - K1 x Vs - K2 x Ws
ergibt.

Fig.1

Fig. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-3 988 684 (SIEMENS)<br>* Figur 3; Spalte 3, Zeilen 4-29 *<br>--- | 1 | G 01 R 15/04 |
| A | DE-A-3 601 934 (FELTEN)<br>--- | | |
| A,D | DE-A-3 121 795 (GOSSEN)<br>--- | | |
| A | IEEE TRANSACTIONS ON POWER APPARATUS AND SYSTEMS, Band 93, Nr. 5, September/Oktober 1974, Seiten 1345-1351; M.B. DEJARNETTE et al.: "A coupling capacitor voltage transformer of metering accuracy for SF6 insulated compact substations"<br>----- | | |

**RECHERCHIERTE SACHGEBIETE (Int. Cl.4)**

G 01 R

Der vorliegende Recherchenbericht wurde für alle Patentansprüche erstellt

| Recherchenort | Abschlußdatum der Recherche | Prüfer |
|---|---|---|
| DEN HAAG | 06-07-1989 | HOORNAERT W. |